# EUROPÄISCHE PATENTSCHRIFT

(11) **EP 2 060 923 B1**
(45) Veröffentlichungstag und Bekanntmachung des Hinweises auf die Patenterteilung: **12.11.2014**
(21) Anmeldenummer: 08105463.7
(22) Anmeldetag: 30.09.2008
(51) Int. Cl.: G01R 15/20, G01R 31/00

(54) **Anordnung zur Messung eines elektrischen Stromes**
Assembly for measuring electric current
Agencement destiné à la mesure d'un courant électrique

(30) Priorität: 14.11.2007 DE 102007054395
(43) Veröffentlichungstag der Anmeldung: 20.05.2009
(73) Patentinhaber: ROBERT BOSCH GMBH, 70442 Stuttgart (DE)
(72) Erfinder: Bremmer, Marcus, 71726, Benningen Am Neckar (DE); Wetzel, Gabriel, 70825, Korntal-Muenchingen (DE)

(56) Entgegenhaltungen:
- EP-A- 0 315 358
- DE-A1- 10 100 597
- JP-A- 2006 184 269

## Beschreibung

### Stand der Technik

Die Erfindung betrifft eine Anordnung zur Messung eines elektrischen Stromes, insbesondere zur Messung eines Batteriestromes in Kraftfahrzeugen, nach der Gattung des Hauptanspruchs.

Um den Batteriezustand in einem Kraftfahrzeug zu ermitteln, kommen in der Regel an sich bekannte Batteriesensoren oder elektronische Batteriemanagementsysteme zum Einsatz. Hierbei ist die Erfassung des Batteriestromes besonders wichtig. Dieser wird entweder mittels eines Shunts oder mittels einer Erfassung des Magnetfeldes im Bereich eines stromführenden Leiters gemessen.

Es ist beispielsweise aus der DE 203 20 473 U1 bekannt, dass eine solche Messung von Batterieströmen im Bordnetz eines Kraftfahrzeuges mit Widerstandselementen durchgeführt wird, die als Shunt für die Strommessung herangezogen werden. Über diesem Shunt wird ein Spannungsabfall gemessen und dann unter Kenntnis des Widerstandswertes des Shunts in einen Strom umgerechnet. Mittels eines geeigneten Kommunikationsweges kann dann dieser Messwert an eine Auswerteeinheit in einem Kraftfahrzeug weitergereicht werden.

Wird der Strom, wie zuvor erwähnt, mittels des Spannungsabfalls über einem Shunt gemessen, so sollte der stromführende Leiter inklusive des Shunts und gegebenenfalls auch inclusive der zugehörigen Auswerteelektronik in dem Gehäuse eines Batteriesensors integriert sein. Das Gehäuse, in der Regel aus Kunststoff, sollte dabei zum Schutz vor Korrosion so ausgeführt werden, dass zwischen dem elektrischen Leiter, zum Beispiel eine Polklemme oder eine Stromschiene etc., und dem Gehäuse keine Feuchtigkeit eindringen kann. Eine solche Vorgehensweise ist sehr aufwendig und kostenintensiv, da die heute verwendeten Kunststoffe mit dem Metall in den meisten Fällen keine dichte Verbindung bilden können.

Wird beispielsweise ein induktives Messprinzip zur Strommessung angewandt, so muss der magnetische Fluss, der durch den Stromfluss im Leiter erzeugt wird, in einem Flusskonzentrator zu einer Messsonde geführt werden. Dieser Flusskonzentrator muss konzentrisch um den stromführenden Leiter geführt werden. Ein Vorteil dieses Prinzips ist, dass die oben erwähnte Dichtheitsproblematik nicht besteht. Die Montage eines auf diesem Messprinzip basierenden Batteriesensors ist jedoch insofern nachteilig, dass die jeweilige Polklemme zum Anschluss des Batteriekabels an die Batterie im Durchmesser in der Regel größer ist als die Öffnung im Batteriesensor. Der Batteriesensor muss also in nachteiliger Weise vor der Montage des Fahrzeugs über den stromführenden Leiter geführt und befestigt werden.

Eine solche Strommessung über eine Messung des Magnetfeldes am stromführenden Leiter ist beispielsweise aus der DE 101 00 597 A1 bekannt. Hier wird der stromführende Leiter mit einem Schlitz versehen, in den eine Reihe von magnetfeldempfindlichen Sensoren, wie zum Beispiel Hallelemente oder magnetoresistive Widerstände, zur Strommessung installiert sind.

### Offenbarung der Erfindung

Die Erfindung geht von einer Anordnung zur Messung eines elektrischen Stromes mit magnetfeldempfindlichen Sensoren an einem stromführenden Leiter aus, der, wie für sich gesehen aus der DE 101 00 597 A1 bekannt, mit einem Schlitz im stromführenden Leiter versehen ist, in das die magnetfeldempfindlichen Sensoren einbringbar sind. Um eine einfachere Montage am Leiter zu erreichen, sind die magnetfeldempfindlichen Sensoren gemäß der Erfindung in vorteilhafter Weise vor und nach der Montage an dem Leiter fester Bestandteil eines Stromsensors und dessen Gehäuse. Das Gehäuse wird dann komplett am Leiter derart angebracht, dass die magnetfeldempfindlichen Sensoren nach der Montage in den Schlitz hineinragen.

Die vorliegende Erfindung ist vor allem deswegen vorteilhaft, da der stromführende Leiter bei der Montage nicht mehr in das Gehäuse, beispielsweise eines Batteriesensors in einem Kraftfahrzeug, eingeführt werden muss und somit die eingangs erwähnte nachteilige Abdichtungsproblematik entfällt. Ein Batteriesensor als Stromsensor kann jederzeit montiert und in den meisten Fällen auch wieder demontiert werden, ohne dass ein Entfernen der Polklemme der Batterie mit einer anschließenden Neumontage der Polklemme notwendig ist.

Das Gehäuse kann beispielsweise mittels einer Clipsverbindung lösbar am Leiter gehalten werden oder auch mittels einer Einpresstechnik oder Klebetechnik am Leiter befestigt werden. Bei der Einpresstechnik oder Klebetechnik entfällt zwar der Vorteil der Lösbarkeit, jedoch bleibt der Vorteil der Korrossionsfestigkeit durch die erfindungsgemäße sichere Unterbringung der Sensoren im Gehäuse erhalten.

Gemäß einer vorteilhaften Ausführungsform kann das Gehäuse des Strom- oder Batteriesensors mittels Positionierungsstiften zwischen dem Leiter und dem Gehäuse positioniert werden. Ferner kann zur elektrischen Verbindung der Sensoren mit einer Auswerteelektronik das Gehäuse einen Steckkontakt zur Kontaktierung der Sensoren mit einer äußeren Kabelverbindung aufweisen. Die Sensoren können, wie für sich gesehen aus dem Stand der Technik bekannt, aus Hallelementen oder magnetoresistiven Widerständen bestehen.

Besonders vorteilhaft lässt sich die Erfindung anwenden, wenn, wie zuvor erwähnt, der Leiter eine Polklemme oder eine Stromschiene eines Batterieanschlusses zur Stromversorgung in einem Kraftfahrzeug ist.

### Kurze Beschreibung der Zeichnung

Die Erfindung wird nachfolgend anhand des in den Figuren der Zeichnung gezeigten Ausführungsbeispiels erläutert. Dabei zeigen:
Figur 1 eine schematische Darstellung eines stromführenden Leiters, beispielsweise einer Stromschiene oder einer Polklemme an der Batterie eines Fahrzeugs und
Figur 2 einen Schnitt durch die Anordnung nach der Figur 1.

### Ausführungsform der Erfindung

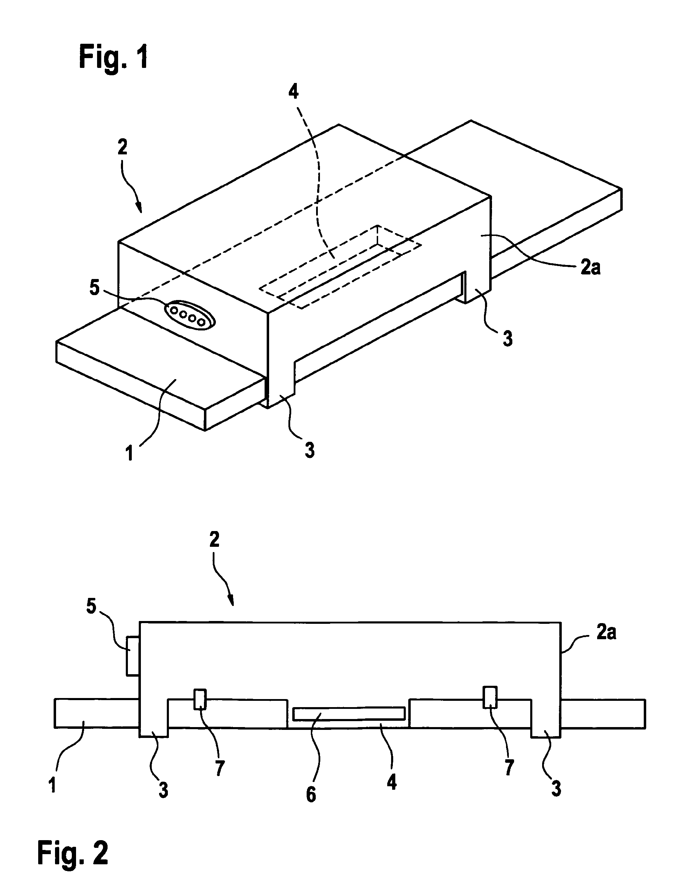

In Figur 1 ist ein stromführender Leiter 1 in einer schematischen Ansicht gezeigt, der beispielsweise eine Stromschiene oder eine Polklemme an der Batterie eines hier nicht näher beschriebenen Fahrzeugs darstellt. Es ist ein Batteriesensor 2 als Stromsensor vorhanden, der mit seinem Gehäuse 2a so ausgeführt ist, dass er auf dem stromführenden Leiter 1 nachträglich montiert werden kann, ohne dass der stromführende Leiter 1 selbst in den Batteriesensor 2 integriert ist.

Figur 2 stellt einen Schnitt durch den Leiter 1 mitsamt dem darauf angebrachten Batteriesensor 2 dar, der über Clips 3 auf dem Leiter 1 lösbar gehalten ist. Aus der Figur 1 und der Figur 2 ist zu erkennen, dass der stromführende Leiter 1 mit einem Schlitz 4 versehen ist. Eine äußere Kontaktierung des Batteriesensors 2 erfolgt über einen Steckkontakt 5, der zur Spannungsversorgung und/oder zur Signalübertragung der Sensorsignale dient. In der Figur 2 ist schematisch mindestens ein magnetfeldempfindlicher Sensor 6 gezeigt, der fest mit dem Batteriesensor 2 im Gehäuse 2a verankert ist und nach der Montage im Schlitz 4 im Leiter 1 zu liegen kommt.

Der Aufbau des Batteriesensors 2 ist damit so ausgeführt, dass die Sensoren 6 zur Strommessung, zum Beispiel Magnetfeldsensoren wie Hallelemente oder magnetoresistive Sensoren, zwar in dem Schlitz 4 positioniert sind, sich aber trotzdem noch in dem Gehäuse 2a des Batteriesensors 2 befinden,

Über die Clips 3 wird der Batteriesensor 2 auf dem Leiter 1 positioniert, wobei jedoch für eine noch exaktere Positionierung des Batteriesensors 2 zusätzliche Positionierungsstifte 7 in beliebiger Anzahl verwendet werden können, die die Position des Batteriesensors 2 auf dem stromführenden Leiter 1 exakt definieren und damit die Genauigkeit des Systems erhöhen.

Abweichend von dem dargestellten Ausführungsbeispiel können die Clips 3 zur Befestigung des Batteriesensors 2 auch entfallen und der Batteriesensor 2 kann beispielsweise mittels einer Einpresstechnik oder Klebetechnik an dem Leiter 1 fixiert werden.

## Patentansprüche

1. Anordnung zur Messung eines elektrischen Stromes mit magnetfeldempfindlichen Sensoren (6) an einem stromführenden Leiter (1) mit einem Schlitz (4) im stromführenden Leiter (1), in den die magnetfeldempfindlichen Sensoren (6) einbringbar sind, **dadurch gekennzeichnet, dass** die magnetfeldempfindlichen Sensoren (6) vor und nach der Montage an dem Leiter (1) fester Bestandteil eines Stromsensors und dessen Gehäuses (2a) sind und dass das Gehäuse (2a) am Leiter (1) derart angebracht ist, dass die magnetfeldempfindlichen Sensoren (6) nach der Montage in den Schlitz (4) hineinragen.

2. Anordnung nach Anspruch 1, **dadurch gekennzeichnet, dass** das Gehäuse (2a) mittels einer über Clips (3) hergestellten Verbindung lösbar am Leiter (1) gehalten ist.

3. Anordnung nach Anspruch 1, **dadurch gekennzeichnet, dass** das Gehäuse (2a) mittels einer Einpresstechnik oder Klebetechnik am Leiter (1) gehalten ist.

4. Anordnung nach einem der vorhergehenden Ansprüche, **dadurch gekennzeichnet, dass** das Gehäuse (2a) mittels Positionierungsstiften (7) zwischen dem Leiter (1) und dem Gehäuse (2a) positioniert ist.

5. Anordnung nach einem der vorhergehenden Ansprüche, **dadurch gekennzeichnet, dass** das Gehäuse (2a) einen Steckkontakt (5) zur Kontaktierung der Sensoren (6) mit einer äußeren Kabelverbindung aufweist.

6. Anordnung nach einem der vorhergehenden Ansprüche, **dadurch gekennzeichnet, dass** die Sensoren (6) Hallelemente oder magnetoresistive Widerstände aufweisen.

7. Anordnung nach einem der vorhergehenden Ansprüche, **dadurch gekennzeichnet, dass** der Leiter (1) eine Polklemme oder eine Polschiene eines Batterieanschlusses zur Stromversorgung in einem Kraftfahrzeug ist und dass der Stromsensor ein Batteriesensor (2) ist.

## Claims

1. Arrangement for measuring an electric current with magnetic field-sensitive sensors (6) on a current carrying conductor (1) with a slot (4) in the current carrying conductor (1), it being possible for the magnetic field-sensitive sensors (6) to be inserted into the said slot, **characterized in that** the magnetic field-sensitive sensors (6) are fixed constituent parts of a current sensor and of the housing (2a) of the said current sensor before and after mounting on the conductor (1), and **in that** the housing (2a) is fitted to the conductor (1) in such a way that the magnetic field-sensitive sensors (6) project into the slot (4) after mounting.

2. Arrangement according to Claim 1, **characterized in that** the housing (2a) is held on the conductor (1) in a detachable manner by means of a connection which is produced by means of clips (3).

3. Arrangement according to Claim 1, **characterized in that** the housing (2a) is held on the conductor (1) by means of press-fit technology or adhesive-bonding technology.

4. Arrangement according to one of the preceding claims, **characterized in that** the housing (2a) is positioned between the conductor (1) and the housing (2a) by means of positioning pins (7).

5. Arrangement according to one of the preceding claims, **characterized in that** the housing (2a) has a plug contact (5) for making contact with the sensors (6) by way of an external cable connection.

6. Arrangement according to one of the preceding claims, **characterized in that** the sensors (6) have Hall elements or magnetoresistive resistors.

7. Arrangement according to one of the preceding claims, **characterized in that** the conductor (1) is a pole terminal or a pole rail of a battery connection for supplying power in a motor vehicle, and **in that** the current sensor is a battery sensor (2).

## Revendications

1. Agencement destiné à la mesure d'un courant électrique, comprenant des capteurs sensibles aux champs magnétiques (6) sur un conducteur (1) conduisant le courant, avec une fente (4) dans le conducteur (1) conduisant le courant, dans laquelle peuvent être introduits les capteurs sensibles aux champs magnétiques (6), **caractérisé en ce que** les capteurs sensibles aux champs magnétiques (6), avant et après le montage sur le conducteur (1), sont un constituant fixe d'un capteur de courant et de son boîtier (2a) et **en ce que** le boîtier (2a) est monté sur le conducteur (1) de telle sorte que les capteurs sensibles aux champs magnétiques (6) pénètrent dans la fente (4) après le montage.

2. Agencement selon la revendication 1, **caractérisé en ce que** le boîtier (2a) est maintenu de manière desserrable sur le conducteur (1) au moyen d'une connexion établie par le biais de pinces (3).

3. Agencement selon la revendication 1, **caractérisé en ce que** le boîtier (2a) est maintenu sur le conducteur (1) au moyen d'une technique de pressage ou d'une technique de collage.

4. Agencement selon l'une quelconque des revendications précédentes, **caractérisé en ce que** le boîtier (2a) est positionné au moyen de goupilles de positionnement (7) entre le conducteur (1) et le boîtier (2a).

5. Agencement selon l'une quelconque des revendications précédentes, **caractérisé en ce que** le boîtier (2a) présente un contact enfichable (5) pour mettre en contact les capteurs (6) avec une connexion de câble extérieure.

6. Agencement selon l'une quelconque des revendications précédentes, **caractérisé en ce que** les capteurs (6) présentent des éléments de Hall ou des résistances magnétorésistives.

7. Agencement selon l'une quelconque des revendications précédentes, **caractérisé en ce que** le conducteur (1) est une borne polaire ou une barrette à pôles d'un raccord de batterie pour l'alimentation électrique dans un véhicule automobile et **en ce que** le capteur de courant est un capteur de batterie (2).
